# DEMANDE DE BREVET EUROPEEN

(11) **EP 4 486 074 A1**
(43) Date de publication de la demande: **01.01.2025**
(21) Numéro de dépôt: 24185478.5
(22) Date de dépôt: 28.06.2024
(51) Int. Cl.: H05K 1/02, H05K 1/16, H05K 1/18

(54) **CIRCUIT IMPRIMÉ COMPORTANT AU MOINS DEUX COMMUTATEURS DE PUISSANCE**

(30) Priorité: 29.06.2023 FR 2306862
(71) Demandeur: Commissariat à l'Energie Atomique et aux Energies Alternatives, 75015 Paris (FR)
(72) Inventeur: LANNELUC, Charley, 38054 GRENOBLE CEDEX 9 (FR); PERICHON, Pierre, 38054 GRENOBLE CEDEX 9 (FR)
(74) Mandataire: Lavoix

(57) **Abrégé**

Ce circuit imprimé comporte, sur une carte électronique multicouches (32), au moins deux commutateurs de puissance, dont au moins un comporte au moins un composant à semi-conducteurs à large bande (40,42), et un composant capacitif de découplage (46), formant un circuit électrique de commutation. Le ou chaque composant à semi-conducteurs à large bande (40, 42) est un composant indépendant monté en surface, sur une première couche conductrice (34). Ce circuit comporte au moins une piste conductrice (54), formée sur une deuxième couche conductrice (38) et située en regard du ou des composant(s) à semi-conducteurs à large bande (40, 42), permettant une circulation de courant électrique dans ledit au moins un composant à semi-conducteurs à large bande (40, 42) dans un premier sens sur la première couche conductrice (34) et une circulation de courant électrique dans un deuxième sens, opposé au premier sens, sur la deuxième couche conductrice (38), formant ainsi un effet d'inductance mutuelle.

## Description

La présente invention concerne un circuit imprimé du type comprenant au moins deux composants commutateurs de puissance, dont au moins un comporte au moins un composant à semi-conducteurs à large bande.

L'invention se situe dans le domaine de l'électronique, et trouve des applications notamment dans l'électronique de puissance.

L'utilisation des composants à semi-conducteurs à base de silicium pour la mise au point de composants électroniques, par exemple de transistors et de diodes, est bien connue.

Plus récemment ont été mis au point des semi-conducteurs à large bande (ou WBG pour « Wide BandGap » en anglais), notamment à base de Nitrure de Gallium (GaN) ou de carbure de Silicium (SiC). Les semi-conducteurs à large bande ont une bande interdite, entre la bande de valence et la bande de conduction, significativement plus importante que celle du silicium, ce qui permet d'atteindre des performances supérieures. Les semi-conducteurs à large bande présentent des pertes en commutation et en conduction plus faibles que les semi-conducteurs en silicium à calibre de courant et de tension donné, ce qui permet une augmentation de leur rendement, notamment dans leur utilisation dans des convertisseurs de puissance. De plus, la vitesse de commutation entre une position d'ouverture et une position de fermeture est plus élevée.

De tels composants sont avantageusement utilisés dans des circuits de commutation (ou mailles de commutation), par exemple pour des applications de commutation de puissance ou de contrôle de transistors.

Une maille de commutation est un circuit qui effectue un transfert d'énergie électrique entre deux systèmes, ces systèmes étant respectivement des sources de courant et/ou de tension. La maille de commutation comporte au moins deux composants à semi-conducteurs, qui commutent chacun entre une position ouverte et une position fermée, de sorte que lorsque l'un des composants est ouvert, l'autre est fermé et vice-versa

Les composants à semi-conducteurs large bande sont en général encapsulés dans un boîtier adéquat, par exemple un boîtier de type TO247 pour les semi-conducteur en carbure de silicium.

De tels composants encapsulés sont également appelés composants discrets.

L'intégration de plusieurs composants à semi-conducteur à large bande dans un circuit imprimé, les composants étant indépendants et montés en surface, par exemple pour former un circuit électrique de commutation (ou maille de commutation) pose problème. En effet, la commutation rapide, en particulier l'ouverture des semi-conducteurs, induit des inductances parasites à l'intérieur de chaque composant, ainsi que de fortes surtensions qui risquent d'endommager les composants. De plus, des courants parasites sont générés dans les pistes conductrices du circuit imprimé, ce qui engendre des inductances parasites dues au circuit imprimé, ce qui risque de dégrader les performances, et même d'endommager les composants. Pour réduire les inductances parasites du circuit imprimé, une solution consisterait à rapprocher les composants.

Classiquement, les circuits sont réalisés avec des composants rapprochés, de manière à minimiser les inductances parasites, mais le rapprochement des composants discrets est limité, en particulier par la taille même des boîtiers encapsulant les composants. Ainsi, des inductances parasites d'environ 1 nanohenry (nH) par millimètre (mm) sont constatées, ce qui n'est pas compatible avec les performances attendues pour un bon fonctionnement.

L'invention a pour but de remédier aux inconvénients de l'état de la technique, en particulier de permettre une protection des composants à semi-conducteurs large bande tout en les intégrant dans un circuit imprimé, pour réaliser un circuit électrique de commutation.

A cet effet, l'invention propose, selon un aspect, un circuit imprimé comportant au moins deux commutateurs de puissance, dont au moins un comporte au moins un composant à semi-conducteurs à large bande, et un composant capacitif de découplage mis en oeuvre sur une carte électronique multicouches, chaque commutateur de puissance étant apte à passer d'une position d'ouverture à une position de fermeture et vice-versa pour former un circuit électrique de commutation étant tel que l'ouverture d'un des commutateurs de puissance provoque la fermeture de l'autre commutateur de puissance.

Ce circuit imprimé est tel que :
- ledit au moins un composant à semi-conducteurs à large bande d'un desdits commutateurs de puissance est un composant indépendant monté en surface, sur une première couche conductrice de la carte électronique multicouches, et
ladite carte électronique multicouches comporte au moins une deuxième couche conductrice séparée de ladite première couche conductrice par une couche isolante, le circuit imprimé comportant une piste conductrice formée sur ladite deuxième couche conductrice, ladite piste conductrice étant située en regard dudit au moins un composant à semi-conducteurs à large bande monté en surface, de manière à permettre une circulation de courant électrique dans ledit au moins un composant à semi-conducteurs à large bande dans un premier sens sur la première couche conductrice et une circulation de courant électrique dans un deuxième sens, opposé au premier sens, sur la deuxième couche conductrice, formant ainsi un effet d'inductance mutuelle, ladite piste conductrice ayant localement une largeur au moins égale à une largeur projetée sur la deuxième couche conductrice du composant à semi-conducteurs à large bande monté en regard, en surface sur la première couche conductrice.

Avantageusement, la formation d'un effet d'inductance mutuelle permet de réduire au maximum les inductances parasites du circuit pour des composants à semi-conducteurs montés en surface du circuit imprimé, ce qui permet d'éviter l'endommagement des composants et de préserver les performances du circuit électrique de commutation réalisé.

Le circuit imprimé peut également présenter une ou plusieurs des caractéristiques ci-dessous, prises indépendamment ou selon toutes les combinaisons techniquement envisageables.

Le circuit imprimé est tel que ladite piste conductrice a une largeur au moins égale à une largeur maximale projetée sur la deuxième couche conductrice des composants indépendants à semi-conducteurs à large bande montés en surface sur la première couche conductrice.

La piste conductrice a une largeur sensiblement égale à la largeur maximale projetée sur la deuxième couche conductrice des composants indépendants à semi-conducteurs à large bande montés en surface sur la première couche conductrice.

Le circuit imprimé comporte un premier commutateur de puissance bidirectionnel en courant et en tension, ledit premier commutateur comportant deux composants à semi-conducteurs à large bande, connectés en sens opposés, lesdits composants à semi-conducteurs à large bande étant des composants indépendants montés en surface sur ladite première couche conductrice de la carte électronique multicouches.

Chacun des composants à semi-conducteurs à large bande est un composant en Nitrure de Gallium ou en Carbure de Silicium.

Un deuxième commutateur de puissance est constitué sous forme de diode à semi-conducteur.

La diode à semi-conducteur est réalisée sous forme de composant traversant.

Le circuit imprimé comporte au moins un premier via traversant permettant de connecter une sortie d'un des composants à semi-conducteurs à large bande monté en surface de la première couche conductrice à ladite piste conductrice, et au moins un deuxième via traversant, permettant de connecter ladite piste conductrice de la deuxième couche conductrice vers un chemin de courant de la première couche conductrice.

La première couche conductrice et la deuxième couche conductrice sont espacées, dans l'empilement de couches formant la carte électronique multicouches, d'un espacement inférieur ou égal à 2,5 mm, de préférence inférieur à 1 mm, de préférence de l'ordre de 0,32mm.

Ledit au moins un deuxième via est situé à une distance spatiale inférieure ou égale à 3 mm d'une piste conductrice de ladite première couche conductrice.

Le circuit imprimé est tel que le courant électrique parcourt un chemin de courant de longueur L, et la ou les pistes conductrices formées sur ladite deuxième couche conductrice ont une dimension et un positionnement permettant d'obtenir un effet d'inductance mutuelle sur au moins 50% de ladite longueur L, et de préférence 70% de ladite longueur L.

La piste conductrice formée sur ladite deuxième couche recouvre l'ensemble de ladite deuxième couche conductrice.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 est un schéma électrique d'un circuit électrique de commutation dans lequel sont également représentées l'inductance et la capacité parasite ;
[Fig 2] la figure 2 est une vue schématique de dessus d'un circuit imprimé implémentant un circuit de commutation selon un mode de réalisation ;
[Fig 3] la figure 3 est une vue éclatée des couches du circuit imprimé de la figure 2 selon un mode de réalisation.

L'invention est décrite ci-après dans son application pour la réalisation d'un circuit électrique de commutation, également appelé maille de commutation, sous forme de circuit imprimé.

Un tel circuit imprimé est par exemple utile pour l'intégration de composants dans un système compact, permettant l'interconnexion entre composants pour faire de la détection, de la transmission d'information, de la conversion de puissance etc.

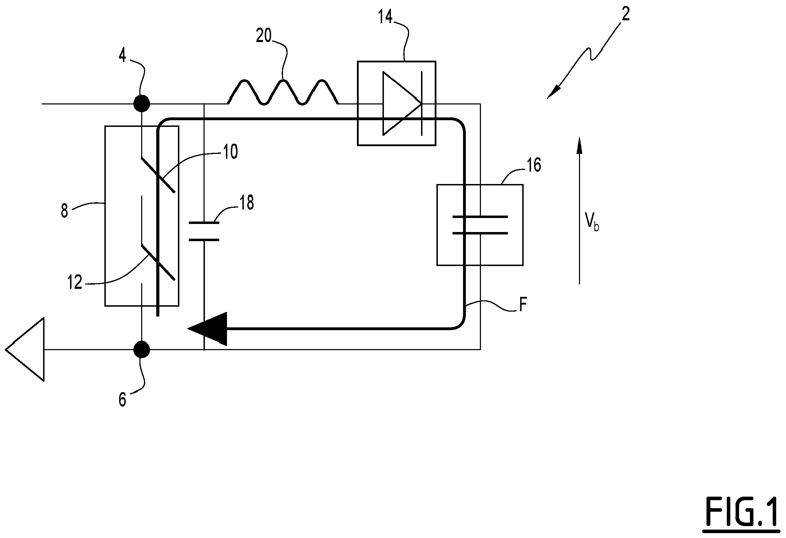

La figure 1 représente le schéma électrique équivalent d'un circuit électrique de commutation 2, qui forme une maille de commutation entre un point d'entrée 4 et un point de sortie 6, à potentiel fixe.

Un tel circuit est adapté pour être connecté entre une source de courant électrique d'entrée et une charge de sortie, non représentées.

Le circuit de commutation 2 comprend un commutateur de puissance 8, bidirectionnel en courant et en tension, formé par deux composants à semi-conducteurs 10,12 montés en sens opposés, ou en d'autres termes, montés tête-bêche.

Dans un mode de réalisation, les composants à semi-conducteurs 10, 12 sont des commutateurs complémentaires, lorsque l'un est ouvert, l'autre est fermé et vice-versa.

Les composants 10, 12 sont de préférence des transistors à semi-conducteurs à base de Nitrure de Gallium (GaN) ou de carbure de Silicium (SiC), qui sont des composants semi-conducteurs à large bande (ou « wide gap »).

Avantageusement, l'utilisation de composants de ce type favorise l'augmentation de la fréquence de commutation.

Le circuit électrique 2 comprend en outre une diode 14, qui est un composant à semi-conducteurs formant un commutateur dans le circuit de commutation 2, ainsi qu'un composant capacitif (e.g. un condensateur) 16, dit composant capacitif de découplage, qui permet d'apporter le courant à la commutation pour recharger les capacités drain-source des transistors lorsque le commutateur de puissance 8 s'ouvre.

En d'autres termes, le circuit de commutation 2 comprend deux commutateurs de puissance, respectivement un premier commutateur de puissance qui est le commutateur 8 et un deuxième commutateur de puissance qui est la diode 14, configurés de sorte que lorsqu'il y a une action sur un commutateur de puissance (ex ouverture), il y a une réponse opposée d'un autre commutateur de puissance (ex fermeture).

Lorsque le commutateur de puissance 8 est fermé, le courant électrique circule au travers de ce composant, la capacité drain-source associée est déchargée, et la diode 14 est bloquée, la capacité drain-source associée à la diode est chargée à la tension V_{b} entre les bornes du condensateur 16.

Lorsque le commutateur de puissance 8 s'ouvre, la capacité drain-source associée se charge et la diode 14 est passante, la capacité drain-source associée à la diode se décharge.

Ensuite, lorsque le commutateur de puissance 8 se ferme, une commutation dite commutation dure s'opère, la capacité drain-source associée au commutateur de puissance se décharge, la diode 14 se bloque et la capacité drain-source associée à la diode se charge.

En outre, sont représentés schématiquement à la figure 1 la capacité parasite 18 et l'inductance parasite 20, qui apparaissent avec les fronts de tension et de courant lors de la commutation. En particulier, la présence de capacité parasite 18 et d'inductance parasite 20 engendre des oscillations et des surtensions lors des commutations.

Il est important de limiter autant que possible les éléments parasites afin de préserver la performance de commutation et de protéger les composants du circuit.

La flèche F illustre le sens de circulation du courant électrique dans le circuit électrique de commutation 2, lorsque la diode 14 est passante.

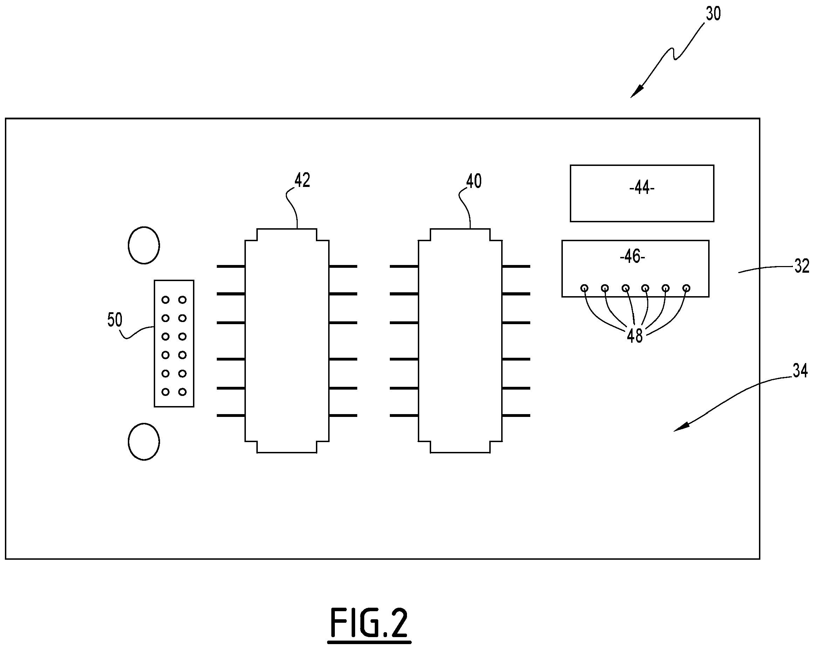

En pratique, le circuit électrique de commutation 2 est réalisé sous forme de circuit imprimé 30, tel qu'illustré schématiquement dans la figure 2, par intégration de composants discrets, montés sur une carte de support 32, au moins une partie des composants étant montés sur la surface d'une couche conductrice 34 de la carte 32.

Dans un mode de réalisation, la carte de support 32 est une carte électronique multicouches, formée d'un empilement de couches (en anglais « multi-layer PCB »), formant une structure en sandwich de couches conductrices et couches isolantes. Ainsi, le circuit imprimé réalisé est un circuit imprimé multicouches.

La technologie des circuits imprimés multicouches est bien connue. Dans un tel circuit imprimé multicouches, deux couches conductrices successives de l'empilement sont séparées par une couche isolante, la carte de support comportant en outre des trous (ou vias), traversants ou borgnes, métallisés, permettant d'établir une connexion électrique entre couches conductrices.

Un tel circuit imprimé comporte deux couches conductrices externes, et un nombre de couches internes.

Les couches conductrices sont en matériau conducteur, par exemple en cuivre, et sont gravées par un procédé chimique pour obtenir un ensemble de pistes conductrices, ce qui permet d'obtenir un ensemble de pistes, terminées par des pastilles, qui permettent de relier électriquement des portions du circuit imprimé. Les pastilles, lorsqu'elles sont perforées, permettent d'établir des connexions entre composants soudés à travers le circuit imprimé, ou entre couches. Certains composants discrets, encapsulés dans des boîtiers propres, sont montés sur la première couche conductrice 34 (qui est une couche externe), qui comporte des zones conductrices (pistes ou connexions de surface), et soudés ou brasés sur des connexions de surface de la couche externe.

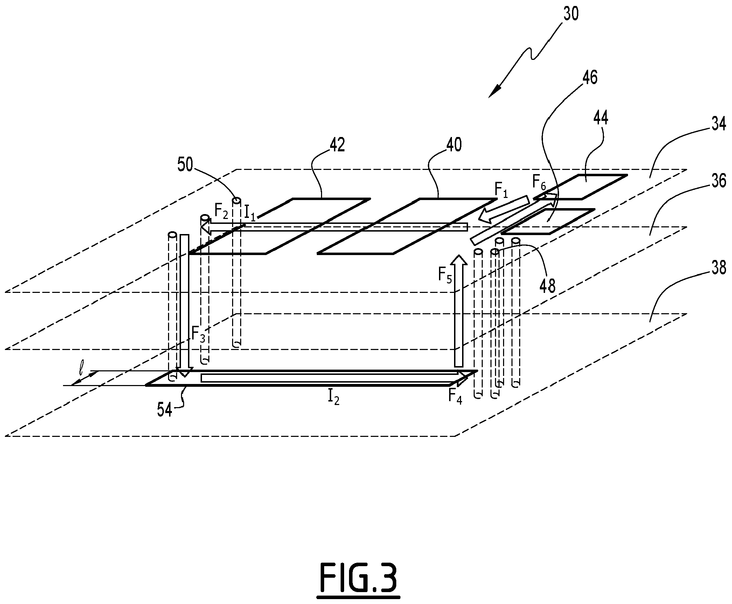

Dans le mode de réalisation des figures 2 et 3, le circuit comporte au moins trois couches, à savoir la couche conductrice 34, une couche isolante 36 et une autre couche conductrice 38, ces couches étant illustrées dans la vue éclatée de la figure 3.

Dans la figure 3 sont représentées en vue éclatée une pluralité de couches du circuit imprimé 30.

Il est à noter que dans des modes de réalisation, le circuit imprimé 30 peut comprendre un nombre quelconque de couches superposées telles que celles représentées dans la figure 3.

Dans la figure 3 on a représenté la première couche conductrice 34 (ou couche externe), la deuxième couche conductrice 38, et la couche isolante 36 les séparant, ainsi que les composants 40, 42 montés en surface sur la première couche conductrice 34, et le composant traversant 44.

La ou les piste(s) conductrice(s) 54 sont positionnées en regard (ou en vis-à-vis) des composantes à semi-conducteurs 40, 42, i.e. dans une zone située directement en dessous des composantes à semi-conducteurs 40, 42.

Pour réaliser le circuit électrique de commutation, des commutateurs à semi-conducteurs large bande 40, 42, formant le commutateur de puissance bidirectionnel courant/tension référencé 8 dans la figure 1, sont montés en surface. Ils correspondent aux composants à semi-conducteurs 10,12 du circuit électrique de commutation 2.

La diode 14 est réalisée par un composant 44 qui est par exemple un composant à semi-conducteurs traversant.

Dans d'autres modes de réalisation envisageables, la diode 14 est réalisée par un composant monté en surface.

Le composant capacitif de découplage 46, est connecté par des vias 48, qui sont des vias traversants conducteurs d'électricité (également appelés des vias de connexion) entre la première couche conductrice 34 et la deuxième couche conductrice 38, dans le circuit électrique de commutation, et est situé à proximité d'un des deux commutateurs à semi-conducteurs, qui est le commutateur 40 dans la figure 2.

Dans le mode de réalisation illustré dans la figure 2, le composant capacitif de découplage 46 est inséré dans la première couche conductrice 34. Selon des variantes, le composant capacitif de découplage 46 est inséré dans une couche inférieure de l'empilement du circuit imprimé, par exemple dans la deuxième couche conductrice 38.

Le circuit imprimé 30 comporte un nombre de vias traversants50 à proximité de l'autre des deux commutateurs à semi-conducteurs, qui est le commutateur 42 dans la figure 2.

Les vias 48, et les via 50 sont des vias métallisés, traversant la première couche 34, la couche isolante 36, de manière à permettre une connexion électrique entre des parties de la première couche 34 et des parties de la deuxième couche 38.

Avantageusement, et comme cela ressort de la représentation schématique de la figure 3, un effet d'inductance mutuelle est engendré par la réalisation d'une ou des pistes conductrices 54 formées sur la deuxième couche conductrice 38, séparée de la première couche conductrice 34 par la couche isolante 36, les pistes 54 ainsi formées étant situées en regard des composants à semi-conducteurs 40, 42.

La ou chaque piste conductrice 54 est connectée électriquement, par contact métallique, à l'un au moins des vias 50 à une première extrémité, et à un autre au moins des vias 48 à l'autre extrémité, opposée à la première extrémité, de la ou chaque piste conductrice 54.

Grâce à cet agencement, l'inductance parasite du circuit, qui est dûe au champ magnétique créé autour des pistes conductrices lors de la circulation d'un courant électrique est quasiment annulée par l'effet d'inductance mutuelle obtenu.

Divers modes de réalisation sont envisageables pour réaliser la ou les pistes conductrices 54.

Dans un mode de réalisation, la piste conductrice 54 forme une bande conductrice de largeur déterminée en fonction des plans de connexions, en fonction de la puissance à acheminer, et également pour maximiser l'effet d'inductance mutuelle.

Dans un mode de réalisation, la piste conductrice 54 est formée, en regard de la première couche conductrice 34, et plus particulièrement en regard des composants à semi-conducteurs 40, 42.

De préférence, la piste conductrice 54 a une largeur ℓ au moins égale, de préférence encore sensiblement égale, à la largeur maximale projetée sur la deuxième couche 38 des composants indépendants 40, 42. La largeur maximale désigne la plus grande des largeurs projetées de chacun des composants. Bien entendu, si les deux composants indépendants 40, 42 sont contenus dans des boîtiers de mêmes dimensions, ils ont la même largeur, qui est alors de fait la largeur maximale. Avantageusement, ce choix de largeur de piste conductrice 54 permet de maximiser l'effet d'inductance mutuelle.

Plus généralement, si les deux composants indépendants 40, 42 sont contenus dans des boîtiers de dimensions différentes, la piste conductrice 54 a localement une largeur au moins égale, et de préférence sensiblement égale, à la largeur projetée du composant indépendant 40, 42 situé en regard. En d'autres termes, la piste conductrice 54 est de largeur qui peut être variable et distincte en regard de chacun des composants indépendants. Avantageusement, la quantité de matière de la piste conductrice est minimisée, la masse du circuit imprimé est diminuée.

De préférence, la largeur de la piste conductrice 54 est en outre et si besoin augmentée de manière supporter la puissance électrique correspondante.

Il est à noter que le chemin du courant à l'intérieur des composants indépendants 40, 42 n'est pas connu, ces composants étant contenus dans des boîtiers. Avantageusement, la prise en compte des projetés des composants indépendants 40, 42 pour la définition de la piste conductrice 54 permet d'assurer que le courant prendra le chemin de cette piste conductrice 54 dans la deuxième couche, en assurant la maximisation de l'inductance mutuelle.

Dans un autre mode de réalisation, la piste conductrice 54 recouvre la totalité de la surface de la couche 38.

Selon une autre variante, plusieurs pistes conductrices 54 sont tracées sensiblement en parallèle, dont au moins une se trouvant directement en regard des composants à semi-conducteurs 40, 42.

Dans un mode de réalisation, au moins un des vias 48 est situé à une distance spatiale inférieure ou égale à 3 mm d'une piste conductrice de la première couche conductrice 34.

De préférence, au moins un des vias 48 débouche à proximité, i.e. à distance inférieure ou égale à 3 mm du chemin de courant symbolisé par les flèches F1 ou F2 sur la figure 3 sur la première couche 34. Ceci est d'autant plus important quand la couche conductrice 54 est de surface importante et dépasse largement le simple vis-à-vis des boitiers 40 et 42, et donc qu'il pourrait être possible de disposer des vias, et donc des débouchés de vias 48, éloignées des chemins de courant F1 ou F2. Cette localisation des débouchés des vias 48 assure un chemin de courant à la fois bien superposé entre F2 et F4, et une proximité des chemins de courant F1 et F6, et par conséquent la maximisation de l'effet d'inductance mutuelle.

On a illustré par des flèches F1, F2, F3, F4, F5, F6 le sens de circulation du courant électrique dans le circuit imprimé 30, lors d'une commutation dure, qui peut être critique pour les composants, potentiellement sujets à des surtensions lors de cette commutation dure. Il s'agit de l'étape de commutation lors de laquelle le commutateur de puissance se ferme, la diode 44 se bloque et la capacité drain-source associée se charge à la tension V_{b} entre les bornes du composant capacitif de découplage.

Le courant électrique suit le sens de circulation indiqué par les flèches F1 et F2 dans la couche supérieure 34, en traversant les composants 40, 42, atteint les vias 50, et, grâce à la connexion intercouches (flèche F3), traverse la couche isolante 36 et atteint la deuxième couche conductrice 38.

Le courant électrique circule alors dans le sens de la flèche F4, inverse au sens de la flèche F2, le long de la piste conductrice 54 de la deuxième couche conductrice 38. En effet, selon un principe physique, le courant à haute fréquence suit un chemin de courant d'impédance/d'inductance minimum.

De préférence, la première couche conductrice 34 et la deuxième couche conductrice 38 sont espacées, dans l'empilement de couches formant la carte 32, d'un espacement inférieur ou égal à 2,5 mm, de préférence encore inférieur à 1 mm, et par exemple de l'ordre de 0,32mm. Les distances entre des chemins de courant en vis-à-vis sur ces deux couches ont ainsi des valeurs similaires.

La proximité des première et deuxième couches permet d'obtenir un effet d'inductance mutuelle entre le courant I₁ circulant dans la première couche conductrice 34 dans le sens de la flèche F2 et le courant I₂ circulant dans la deuxième couche conductrice 38 dans le sens de la flèche F4.

Si les courants respectifs I₁ et I₂ sont de même intensité, ils produisent chacun le même champ magnétique, et alors les champs magnétiques s'annulent. Ainsi, l'effet d'inductance mutuelle est obtenu, et l'inductance parasite de circuit est annulée.

Grâce à la connexion intercouches réalisée par les vias 48, le courant I₂ circulant dans la deuxième couche conductrice traverse vers la première couche conductrice 34 (flèche F5) et est dirigé vers le composant capacitif de découplage 46 (flèche F6).

Le chemin de courant, représenté schématiquement par les flèches F1, F2, F3, F4, F5 et F6, forme une boucle de courant de longueur L, dont une partie est en inductance mutuelle (e.g. la partie représentée par les flèches F2 et F4), cette partie représentant une portion au moins égale à 50% de la longueur L, et de préférence supérieure à 70% de la longueur L du chemin de courant total.

Des tests de simulation ont permis de montrer qu'un espacement de 0,32mm entre les couches conductrices 34 et 38 permet d'obtenir une inductance parasite de 6nH pour une haute fréquence de commutation, supérieure à 1 MHz, cette inductance parasite augmentant avec l'espacement entre les couches conductrices 34 et 38, et pouvant atteindre plus de 9nH pour un espacement de 1mm.

Ainsi, l'invention permet de réaliser des circuits électriques de commutation supportant 10 Ampères et plus, avec une inductance parasite du circuit de quelques nanohenry (nH) seulement, typiquement inférieure à 10 nH pour 10A.

L'effet d'inductance mutuelle permettant d'annuler l'inductance parasite est obtenu, grâce à l'ajout de pistes conductrices dans la deuxième couche, séparées de la première couche par une couche isolante, pour les composants montés en surface.

L'effet d'inductance mutuelle n'est pas applicable pour les composants traversant, par exemple pour la diode 44 de l'exemple de la figure 2, mais cela représente, dans l'exemple, un faible pourcentage, typiquement inférieur à 20%, de l'inductance parasite totale du circuit imprimé.

Ainsi, avantageusement, l'invention permet de limiter fortement l'inductance parasite d'un circuit imprimé pour réaliser un circuit électrique commutation comportant des composants à semi-conducteur à large bande, et d'atteindre une inductance parasite inférieure à 10nH pour une fréquence de commutation supérieure à 1MHz.

Avantageusement, grâce à la minimisation des inductances parasites, les surtensions se produisant à l'ouverture des commutateurs en commutation dure sont minimisées.

Avantageusement, l'agencement de circuit électrique de commutation proposé permet de réduire les oscillations drain-source des composants du commutateur de puissance, ce qui permet de maximiser les performances de commutation et de minimiser les perturbations électromagnétiques.

L'invention a été décrite ci-dessus dans un mode de réalisation d'un circuit de commutation comportant un premier commutateur de puissance bidirectionnel en courant et en tension, et un deuxième commutateur de puissance sous forme de diode.

L'invention s'applique également pour des agencements différents de circuit de commutation, par exemple avec un deuxième commutateur de puissance actif à la place d'une diode.

## Revendications

1. Circuit imprimé comportant au moins deux commutateurs de puissance (8, 14), dont au moins un comporte au moins un composant à semi-conducteurs à large bande (10, 12 ; 40,42), et un composant capacitif de découplage (16 ; 46) mis en oeuvre sur une carte électronique multicouches (32), chaque commutateur de puissance étant apte à passer d'une position d'ouverture à une position de fermeture et vice-versa pour former un circuit électrique de commutation étant tel que l'ouverture d'un des commutateurs de puissance (8, 14) provoque la fermeture de l'autre commutateur de puissance (14 ,8), **caractérisé en ce que** :
- ledit au moins un composant à semi-conducteurs à large bande (40, 42) d'un desdits commutateurs de puissance (8) est un composant indépendant monté en surface, sur une première couche conductrice (34) de la carte électronique multicouches (32),
et **en ce que**
- ladite carte électronique multicouches (32) comporte au moins une deuxième couche conductrice (38) séparée de ladite première couche conductrice (34) par une couche isolante (36), le circuit imprimé comportant une piste conductrice (54) formée sur ladite deuxième couche conductrice (38), ladite piste conductrice (54) étant située en regard dudit au moins un composant à semi-conducteurs à large bande (40, 42) monté en surface, et de manière à permettre une circulation de courant électrique dans ledit au moins un composant à semi-conducteurs à large bande (40, 42) dans un premier sens sur la première couche conductrice (34) et une circulation de courant électrique dans un deuxième sens, opposé au premier sens, sur la deuxième couche conductrice (38), formant ainsi un effet d'inductance mutuelle, ladite piste conductrice (54) ayant localement une largeur au moins égale à une largeur projetée sur la deuxième couche conductrice (38) du composant indépendant à semi-conducteurs à large bande (40, 42) monté en regard, en surface sur la première couche conductrice (34).

2. Circuit imprimé selon la revendication 1, dans lequel ladite piste conductrice (54) a une largeur au moins égale à une largeur maximale projetée sur la deuxième couche conductrice (38) des composants indépendants à semi-conducteurs à large bande (40, 42) montés en surface sur la première couche conductrice (34).

3. Circuit imprimée selon la revendication 2, dans lequel ladite piste conductrice (54) a une largeur sensiblement égale à la largeur maximale projetée sur la deuxième couche conductrice (38) des composants indépendants à semi-conducteurs à large bande (40, 42) montés en surface sur la première couche conductrice (34).

4. Circuit imprimé selon l'une des revendications 1 à 3, comportant un premier commutateur de puissance (8) bidirectionnel en courant et en tension, ledit premier commutateur comportant deux composants à semi-conducteurs à large bande (10, 12 ; 40, 42), connectés en sens opposés, lesdits composants à semi-conducteurs à large bande étant des composants indépendants montés en surface sur ladite première couche conductrice (34) de la carte électronique multicouches (32).

5. Circuit imprimé selon la revendication 4, dans lequel chacun des composants à semi-conducteurs à large bande est un composant en Nitrure de Gallium ou en Carbure de Silicium.

6. Circuit imprimé selon la revendication 4 ou 5, dans lequel un deuxième commutateur de puissance (14) est constitué sous forme de diode à semi-conducteur.

7. Circuit imprimé selon la revendication 6, dans lequel ladite diode à semi-conducteur est réalisée sous forme de composant traversant.

8. Circuit imprimé selon la revendication 1 à 7, comportant au moins un premier via traversant (50) permettant de connecter une sortie d'un des composants à semi-conducteurs à large bande (42) monté en surface de la première couche conductrice (34) à ladite au moins une piste conductrice (54), et au moins un deuxième via traversant (48), permettant de connecter ladite au moins une piste conductrice (54) de la deuxième couche conductrice (38) vers un chemin de courant de la première couche conductrice.

9. Circuit imprimé selon l'une quelconque des revendications 1 à 8, dans lequel la première couche conductrice (34) et la deuxième couche conductrice (38) sont espacées, dans l'empilement de couches formant la carte électronique multicouches (32), d'un espacement inférieur ou égal à 2,5 mm, de préférence inférieur à 1 mm, de préférence de l'ordre de 0,32mm.

10. Circuit imprimé selon la revendication 8 ou 9, dans lequel ledit au moins un deuxième via (48) est situé à une distance spatiale inférieure ou égale à 3 mm d'une piste conductrice de ladite première couche conductrice (34).

11. Circuit imprimé selon l'une des revendications 1 à 10, dans lequel le courant électrique parcourt un chemin de courant de longueur L, et dans lequel la ou les pistes conductrices (54) formées sur ladite deuxième couche conductrice (38) ont une dimension et un positionnement permettant d'obtenir un effet d'inductance mutuelle sur au moins 50% de ladite longueur L, et de préférence 70% de ladite longueur L.

12. Circuit imprimé selon la revendication 11, dans lequel ladite piste conductrice (54) formée sur ladite deuxième couche recouvre l'ensemble de ladite deuxième couche conductrice.
